Europäisches Patentamt

European Patent Office

Office européen des brevets

(11) Publication number: **0 410 504 A2**

# EUROPEAN PATENT APPLICATION

(21) Application number: 90201912.4

(22) Date of filing: 13.07.90

(51) Int. Cl.5: **C23C 14/54**, C23C 14/56, B01J 3/00

(30) Priority: 26.07.89 IT 4823689

(43) Date of publication of application:
**30.01.91 Bulletin 91/05**

(84) Designated Contracting States:
**CH DE FR GB LI NL SE**

(71) Applicant: CONSORZIO CE.TE.V. CENTRO TECNOLOGIE DEL VUOTO

Via Turanense, Km. 44,452
I-67061 Carsoli (L'Aquila)(IT)

(72) Inventor: **Misiano, Carlo**
Via G.B. Morgagni 22
I-00161 Roma(IT)
Inventor: **Simonetti, Enrico**
viale Marconi, 112
I-00146 Roma(IT)

(54) **A double chamber vacuum plant for deposition processes of thin layers.**

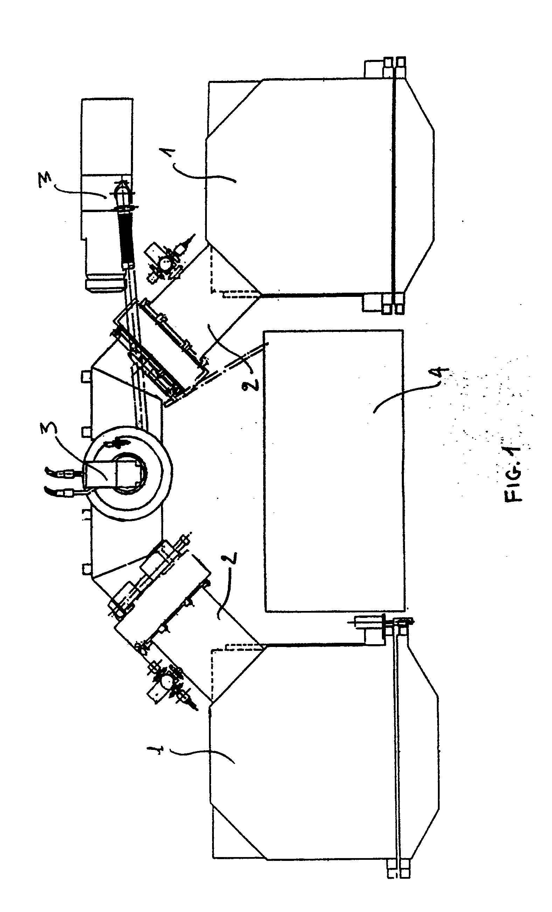

(57) Double chamber vacuum plant for the deposition processes of thin layers, essentially consisting of (Figure.1) two or are deposition chambers (1), one or more pumping groups (2). and an unique complex (4) for the control, to operate and to carry into effect the process. The aforesaid plant have to be used in a laboratory into which must be carried out thin layers treatment.

This plant finds an advantageous employment in the production sector and in the research and development departments.

Compared to the previous techniques, the innovation of the presented invention resides to the double chamber or muultichamber configuration, therefore, it is due to its configuration that can be obtained a nett increasing of the productivity.

Besides, it is possible to specialize the two or more chambers for the deposition materials and differentiated processes.

FIG. 1

EP 0 410 504 A2

# A DOUBLE CHAMBER VACUUM PLANT FOR DEPOSITION PROCESSES OF THIN LAYERS.

The present invention is about a double chamber vacuum plant for deposition processes of thin layers.

The above said plant is usable in its best application to carry into effect thin layers deposition, for the production and for the research and development.

The previous techniques, known to the inventors, are represented with deposition monochamber plant, presenting the well known disadvantages about the impossibility to perform contemporaneous operations, and above all the presence of technical inconvenients to be imputed to the deposition chamber.

For this failure aforesaid the research and the production had to be interrupted.

Moreover, in the presence of great amount of work to be done, we had to possess more plants, otherwise the production was being delay.

The present invention is related to a vacuum plant having more chambers utilizing only one central control system.

It is very important to mention that for the plant economy, the control system is the one more expensive.

It is very remarkable the advantage of having disposable only one control system capable to operate more vacuum chambers, and to be able to get a plant less expensive and of easier realization.

The invention is now going to be described for an illustrative aim and not restrictive, referring to the drawing boards herewith enclosed.

The (Figure. 1) shows a prospect from the top of the scheme double chamber vacuum plant, into which are visible:

1 Deposition chambers.
2 Vacuum conductors.
3 Pumping groups.
4 Computerized central system for the control, for operating and for the process realization.

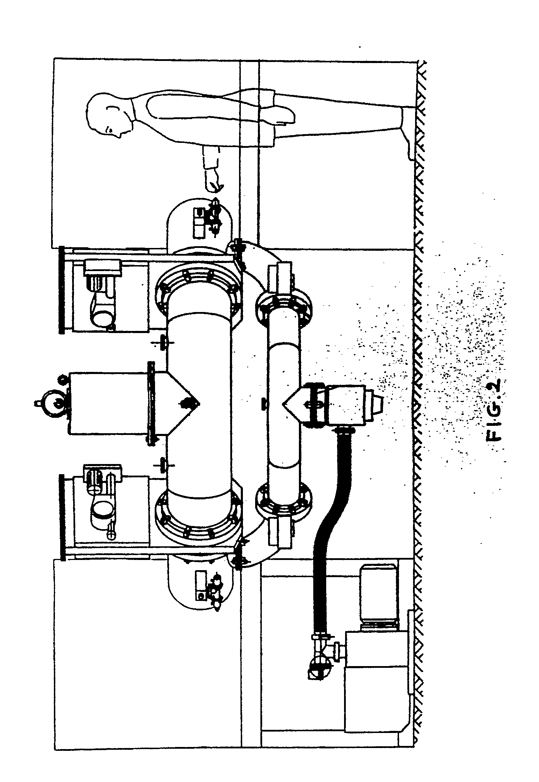

The (Figure. 2) shows a frontal scheme of the system, where without superfluous indications, appears clearly the connections between the pumping groups, deposition chambers, etc, etc.

The method to utilize the plant in the subject, is 11, essentially as it follows: Into the two or more chambers are placed the substrates on which must be carried out the thin layer treatment. During the deposition one chamber is used for the set-up and/or the evacuation, the heating and the eventual preparation to the process in the other or others deposition chambers.

We underline that, although the figures show a plant with only two chambers, besides the control central system, the chambers could be several more.

In this case all the chambers have to be connected everyone to the central system.

## Claims

1) Vacuum plant for deposition processes of thin layers, characterized of being composed with a multichamber structure enslaved to a central unit that allows the execution of the operations simultaneously.

2) Vacuum plant for deposition processes of thin layers, as by claim 1, characterized by the fact that the computerized central system for the control, for operating and for the process realization it is endowed with several connections for all the deposition chambers.

3) Vacuum plant for deposition processes of thin layers, as by claim 1,2, characterized by the fact that each chamber is connected with the pumping groups.

FIG. 1

FIG. 2

4